# EUROPEAN PATENT APPLICATION

(11) **EP 2 096 271 A2**
(43) Date of publication of application: **02.09.2009**
(21) Application number: 09250455.4
(22) Date of filing: 20.02.2009
(51) Int. Cl.: F01D 25/12, F02C 7/12

(54) **System and method for passive cooling of gas turbine engine control components**

(30) Priority: 29.02.2008 US 40126
(71) Applicant: General Electric Company, Schenectady, NY 12345 (US)
(72) Inventor: Diaz, Carlos, Cincinnati Ohio 45252 (US); Laborie, Daniel, West Chester Ohio 45069 (US); Leiva, Orly, Miamisburg Ohio 45342 (US)
(74) Representative: Gray, Thomas

(57) **Abstract**

A system for cooling a gas turbine engine control component (60) comprises a control component (60), at least one duct (63,64) in fluid communication with the component (60) and the atmosphere, and a valve assembly (67) located with the duct (63,64) for modulating airflow to the component (60). A method for cooling a gas turbine engine control component (60) comprises the steps of: a) providing a system for cooling the component (60), the system comprising at least one duct (63,64) in fluid communication with the component (60) and the atmosphere and a valve assembly (67) located with the duct (63,64) for modulating airflow to the component (60); b) exposing the system to a first condition where cooling of the component (60) is required; c) opening the valve assembly (67) in response to the first condition; d) exposing the system to a second condition where cooling of the component (60) is not required; and e) closing the valve assembly (67) in response to the second condition.

## Description

### BACKGROUND OF THE INVENTION

The technology described herein relates generally to gas turbine engines, and more particularly, to a system and method for cooling engine control components for such engines.

At least one known gas turbine engine assembly includes a fan assembly that is mounted upstream from a core gas turbine engine. During operation, a portion of the airflow discharged from the fan assembly is channeled downstream to the core gas turbine engine wherein the airflow is further compressed. The compressed airflow is then channeled into a combustor, mixed with fuel, and ignited to generate hot combustion gases. The combustion gases are then channeled to a turbine, which extracts energy from the combustion gases for powering the compressor, as well as producing useful work to propel an aircraft in flight. The other portion of the airflow discharged from the fan assembly exits the engine through a fan stream nozzle.

A variety of different control systems and methods are available for controlling the operation and performance of such aircraft gas turbine engines. One type of control system is commonly referred to as a FADEC (Full Authority Digital Engine Control), which is a generic name for a system for electronically controlling an aviation engine. A FADEC system includes a central computer system (often referred to as the FADEC) which receives information regarding the position of a throttle lever and other engine control devices operated by a pilot, as well as various information from various sensors fitted to the engine, and controls the engine so as to provide the required levels of performance such as engine thrust, fuel economy, etc. Engine control components such as FADEC units often include a number of small wires and electronic components such as computer chips and printed circuit boards.

In service, gas turbine aircraft engines are subject to a wide range of operating conditions such as high and low altitudes, high and low temperatures, and high and low speed airflows over, around, and through the engine. Even during a single flight, the aircraft, its engine(s), and engine control components may experience low speed, low altitude, and high temperature conditions during taxi, takeoff, and landing operations, as well as high speed, high altitude, and low temperature conditions during the cruise portion of the flight.

Engine control components such as FADEC units are normally housed within the engine cowling or nacelle, where it is protected from precipitation, dirt, debris, and other contaminants which may pass over, around, or through the engine. However, housing the engine control components in close proximity to the engine itself exposes them to potentially high temperatures generated during normal engine operation. Additionally, because of the electrical connections and components, as well as operating computer components which may be inside the engine control component, the engine control components may themselves generate heat which in a confined space tends to expose the unit to higher than desired operating temperatures.

To manage the operating temperatures of the engine control components, ventilation is often provided to direct air which is cooler than the components onto the components to carry heat away and maintain the temperature of the component at a satisfactory operating level. However, cooling needs often vary greatly during the course of a flight or operating session. For example, a much greater degree of cooling may be needed on a hot day during ground operations at engine idle power settings than at high altitude during cruise conditions and high power settings.

Due to the increased weight and complexity which would be required to modulate cooling air flow with conventional systems, such systems normally are configured to operate in a fixed operating condition to provide the maximum level of cooling air volume required during the foreseeable operating environment. However, such a configuration may result in over-cooling or chilling of the engine control components due to greater-than-necessary airflow of low temperature air, thereby inducing thermal fatigue stress and cyclic strain and potentially leading to cracks in sensitive internal elements such as printed circuit boards.

Accordingly, there remains a need for a system and method for cooling gas turbine engine control components as needed while maintaining a satisfactory temperature range for operation of the components.

### BRIEF DESCRIPTION OF THE INVENTION

In one aspect, a system for cooling a gas turbine engine control component is described. The system comprises a control component, at least one duct in fluid communication with the component and the atmosphere, and a valve assembly located with the duct for modulating airflow to the component.

In another aspect, a method for cooling a gas turbine engine control component is described. The method comprises the steps of: a) providing a system for cooling the component, the system comprising at least one duct in fluid communication with the component and the atmosphere and a valve assembly located with the duct for modulating airflow to the component; b) exposing the system to a first condition
where cooling of the component is required; c) opening the valve assembly in response to the first condition; d) exposing the system to a second condition where cooling of the component is not required; and e) closing the valve assembly in response to the second condition.

### BRIEF DESCRIPTION OF THE DRAWINGS

Figure 1 is a cross-sectional illustration of an exemplary gas turbine engine assembly;
Figure 2 is a partial cross-sectional elevational view of an exemplary gas turbine engine, illustrating an exemplary embodiment of an engine control component cooling system installed on the engine with a valve shown in an open position;
Figure 3 is an enlarged cross-sectional view of the valve assembly shown in Figure 2;
Figure 4 is an enlarged cross-sectional view taken along line 4-4 of Figure 2;
Figure 5 is a partial cross-sectional elevational view similar to Figure 2, but illustrating the cooling system of Figure 2 with the valve in a closed position;
Figure 6 is an enlarged cross-sectional view of the valve assembly shown in Figure 5;
Figure 7 is an enlarged cross-sectional view taken along line 7-7 of Figure 7;
Figure 8 is a view similar to Figure 7 of an alternative embodiment of a valve assembly;
Figure 9 is a temperature vs. time plot of the temperatures experienced by an engine control component with a conventional cooling system; and
Figure 10 is a temperature vs. time plot of the temperatures experienced by an engine control component utilizing an exemplary embodiment of the cooling system described herein.

### DETAILED DESCRIPTION OF THE INVENTION

Exemplary embodiments of the present invention will now be described with regard to the accompanying drawing figures, in which like numerals refer to like elements throughout the drawing figures.

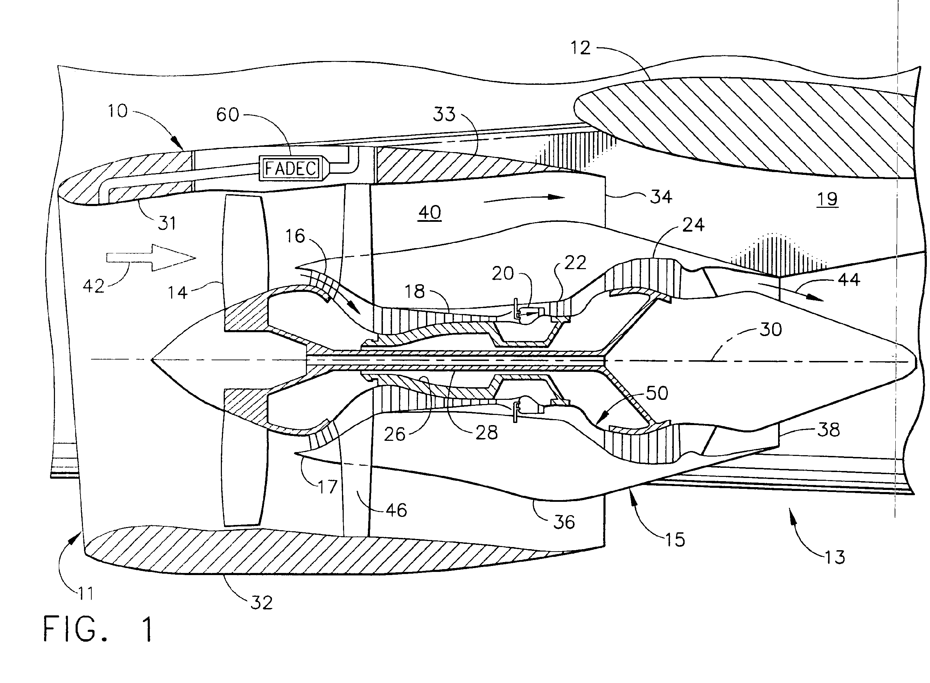

Figure 1 is a cross-sectional schematic illustration of an exemplary gas turbine engine assembly 10 having a longitudinal axis 30. Gas turbine engine assembly 10 includes a fan assembly 14 and a core gas turbine engine 15. Core gas turbine engine 15 includes a high pressure compressor 18, a combustor 20, and a high pressure turbine 22. In the exemplary embodiment, gas turbine engine assembly 10 also includes a low pressure turbine 24, and a multi-stage booster compressor 16, and a splitter 17 that substantially circumscribes booster 16.

Fan assembly 14 includes an array of fan blades extending radially outward from a rotor disk, the forward portion of which is enclosed by a streamlined spinner. Gas turbine engine assembly 10 has an intake side 11 and an exhaust side 13. Fan assembly 14, booster 16, and turbine 24 are coupled together by a first rotor shaft 28, and compressor 18 and turbine 22 are coupled together by a second rotor shaft 26.

In operation, incoming air 42 flows through fan assembly 14 and a first portion of the airflow is channeled through booster 16 and onward through internal flowpath 50 of core gas turbine engine 15. The compressed air that is discharged from booster 16 is channeled through compressor 18 wherein the airflow is further compressed and delivered to combustor 20. Hot products of combustion (not shown in Figure 1) from combustor 20 are utilized to drive turbines 22 and 24, and turbine 24 is utilized to drive fan assembly 14 and booster 16 by way of shaft 28. Air and combustion products flowing through internal flowpath 50 exit the core gas turbine engine 15 at the trailing edge 38 of the core cowl 36 as shown at 44. Gas turbine engine assembly 10 is operable at a range of operating conditions between design operating conditions and off-design operating conditions.

A second portion of the incoming airflow 42 discharged from fan assembly 14 is channeled through a bypass duct 40 to bypass a portion of the airflow from fan assembly 14 around the core cowl 36 which encloses the core gas turbine engine 15. More specifically, bypass duct 40 extends between a fan casing or shroud, which forms a first or inner surface 31 of the engine nacelle 32 and the core cowl 36 which has a leading edge formed by splitter 17. Air flowing through bypass duct 40 exits the trailing edge 34 of the nacelle 32. Nacelle 32 encloses the major portion of the aircraft engine 10 and is secured to the aircraft by appropriate mounting apparatus. In the embodiment shown in Figure 1, the nacelle 32 is secured to the aircraft wing 12 via mounting pylon 19.

Accordingly, a first portion of the airflow from fan assembly 14 is channeled through booster 16 and then into compressor 18 as described above, and a second portion of the airflow from fan assembly 14 is channeled through bypass duct 40 to provide thrust for an aircraft, for example. Splitter 17 divides the incoming airflow into first and second portions. Gas turbine engine assembly 10 also includes a fan frame assembly 46 to provide structural support for fan assembly 14 and is also utilized to couple fan assembly 14 to core gas turbine engine 15.

Fan frame assembly 46 includes a plurality of outlet guide vanes that extend substantially radially between a radially outer mounting flange and a radially inner mounting flange and are circumferentially-spaced within bypass duct 40. Fan frame assembly 46 may also include a plurality of struts that are coupled between a radially outer mounting flange and a radially inner mounting flange. In one embodiment, fan frame assembly 46 is fabricated in arcuate segments in which flanges are coupled to outlet guide vanes and struts. In one embodiment, outlet guide vanes and struts are coupled coaxially within bypass duct 40. Optionally, outlet guide vanes may be coupled downstream from struts within bypass duct 40.

Fan frame assembly 46 is one of various frame and support assemblies of gas turbine engine assembly 10 that are used to facilitate maintaining an orientation of various components within gas turbine engine assembly 10. More specifically, such frame and support assemblies interconnect stationary components and provide rotor bearing supports. Fan frame assembly 46 is coupled downstream from fan assembly 14 within bypass duct 40 such that outlet guide vanes and struts are circumferentially-spaced around the outlet of fan assembly 14 and extend across the airflow path discharged from fan assembly 14.

In the embodiment shown in Figure 1, a control component for gas turbine engine 10 such as a Full Authority Digital Engine Control (FADEC) is located within the engine nacelle 32 between the first or inner surface 31 and the second or outer surface 33.

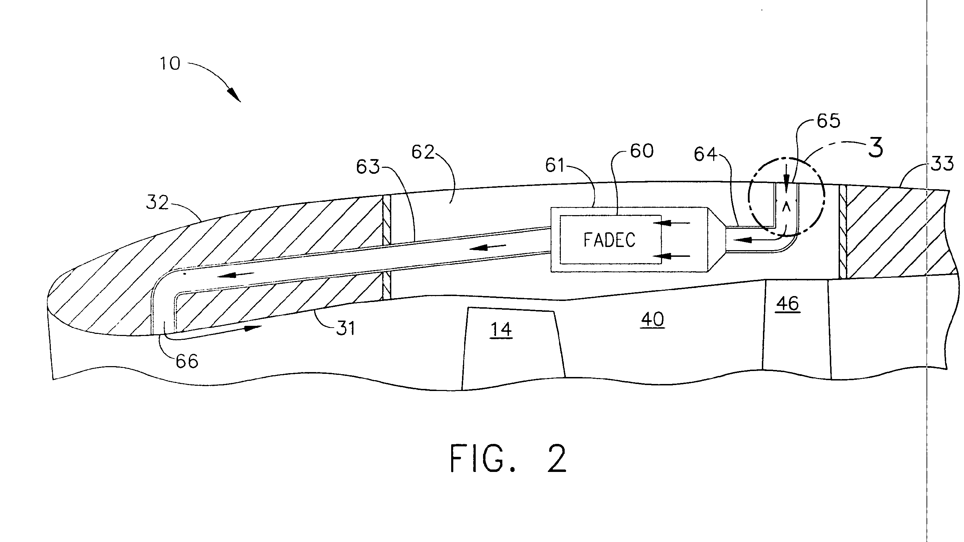

Figure 2 is a partial cross-sectional elevational view of the forward portion of an exemplary aircraft gas turbine engine, such as depicted in Figure 1, illustrating installation details of the engine control component 60. As shown in Figure 2, engine control component 60 is mounted in a compartment 62 within the nacelle 32, which may house other components (not shown) in addition to the engine control component 60. Compartment 62 is located between the inner and outer surfaces, 31 and 33, respectively, of the nacelle 32. Various locations within the nacelle are possible, depending upon installation and construction details of the gas turbine engine 10 and its control and accessory systems. In the embodiment shown, compartment 62 is approximately midway between the leading and trailing edges of the nacelle.

In the exemplary embodiment depicted in Figure 2, the control component 60 is housed in a casing 61, which at least partially surrounds control component 60 to isolate it from the other elements and space inside of the compartment 62. Duct 63 provides fluid communication between an opening 66 on the inner surface 31 and the casing 61, such that air may flow through duct 63 between the casing 61 surrounding control component 60 and the inner surface 31. Duct 64 provides fluid communication between an opening 65 on the outer surface 33 and the casing 61, such that air may flow through duct 64 between the casing 61 surrounding control component and the outer surface 33. Accordingly, control component 60 may be exposed to airflow traveling through ducts 63 and 64 from inner surface 31 and/or outer surface 33.

The elements of the compartment 62, controller casing 61, and ducts 63 and 64 are sized, shaped, adapted, and otherwise configured to suit the characteristics of the particular engine application desired.

As shown in Figure 2, a valve assembly 67 is included to passively modulate airflow through the system and manage the operating temperatures experienced by the engine control component 60.

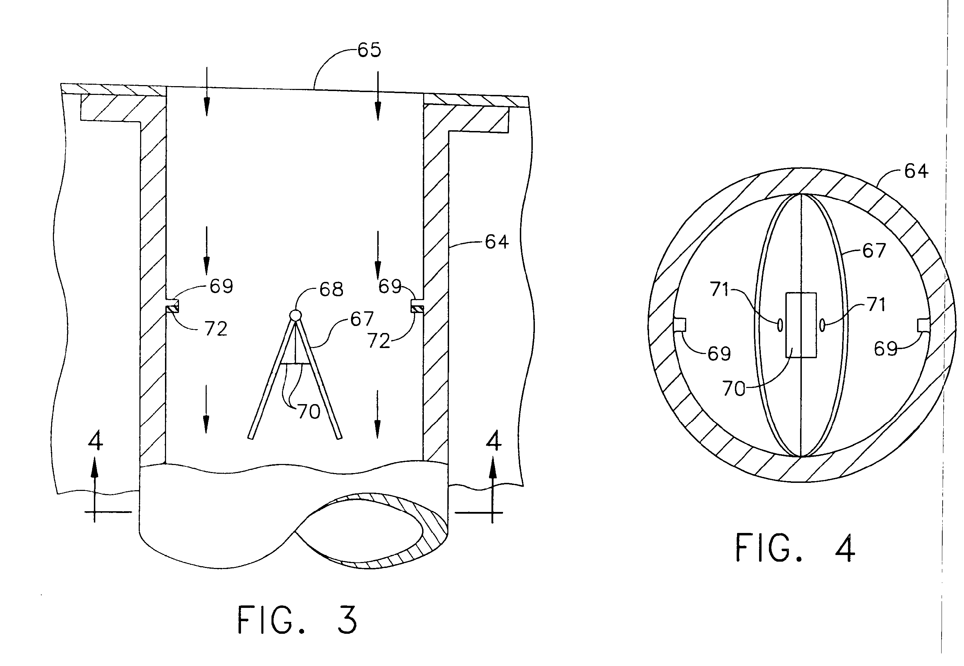

Figures 3 and 4 illustrate in greater detail the valve assembly 67 depicted in Figure 2. As shown in Figures 2, 3, and 4, the valve assembly 67 is in the open position, so that air flows in the direction of the arrows as shown. Accordingly, air flows from opening 65 on the second or outer surface 33 of the nacelle, through duct 64 with the valve assembly 67 in the open position, through casing 61 surrounding control component 60, through duct 63, and out through opening 66 on the first or inner surface 31 of the nacelle. This configuration and operating condition would be typical of a low speed, low Mach number, low altitude operating condition such as ground operations or takeoff. Under such conditions, the temperature differences between that of the air available at opening or port 65 and that of the air inside control component 60 are relatively small, and therefore unrestricted air flow through valve assembly 67 is permissible under thermal shock design considerations.

As shown in Figures 3 and 4, the valve assembly 67 in the exemplary embodiment shown includes two semicircular valve flaps pivotally mounted with a hinge pin 68. The valve assembly 67 is installed such that, in the normal aircraft attitude, gravity acts upon the valve flaps to exert a force on them and bias them downward, to an open position, without any springs, solenoids, or other actuators being necessary. The valve flaps include a feature, such as wedges 70, which prevent the valve flaps from reaching a fully open (i.e., vertical as shown) position where the flaps would contact each other. This feature aids in preventing a flutter situation where dynamic forces of air flowing over the valve flaps could cause them to oscillate and potentially cause vibration and/or premature wear of parts of the valve assembly. A feature which maintains the valve flaps in a slightly closed (not fully open) position also aids in enabling the valve flaps to respond to a change in airflow direction and pressure, such that they respond and move to a closed condition more readily when the airflow reverses direction. The transition point (open/close) is a function of aircraft speed, aircraft angle of attack, and air density. This turning point can be changed by adding to the valve flaps a calibrated weight and changing the position with respect to the turning axis. As will be more fully described below, the valve flaps also include a feature such as apertures 71 to permit a measured, minor amount of airflow through the system when the valve is in a closed position. Also included are one or more valve stops 69 against which the valve flaps rest when in a fully closed condition, to limit their travel and prevent going over-center. The valve stop or stops 69 may also take the form of a complete annular ring, or ring segments, since with the presence of apertures 71 it is not necessary for any particular amount of clearance to be provided at the edges of the valve flaps for the passage of air in the closed position. A bumper or seal 72 may be provided in association with the valve stop or stops 69 to reduce vibration and reduce or prevent air leaks when the valve is closed. For discontinuous valve stops 69, the bumper or seal 72 is also discontinuous, while for a valve stop in the form of a continuous annular ring the bumper or seal 72 may be either continuous (forming an annular ring) or discontinuous (forming one or more annular segments). The degree of influence the bumper or seal 72 has on air passage, i.e., the degree of sealing capability, is dependent upon the degree of continuity of the seal 72. Where the bumper or seal 72 is discontinuous, it tends to function more as a bumper than as a seal.

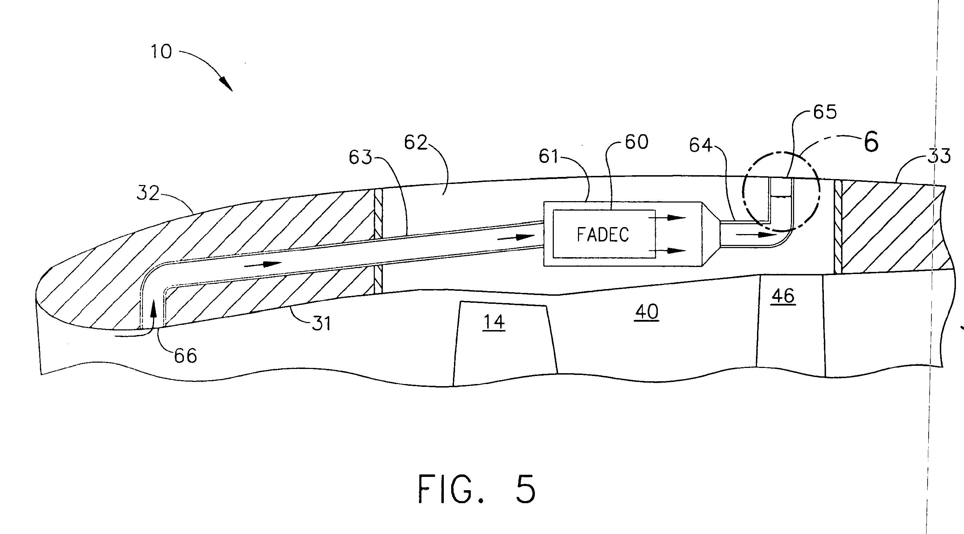

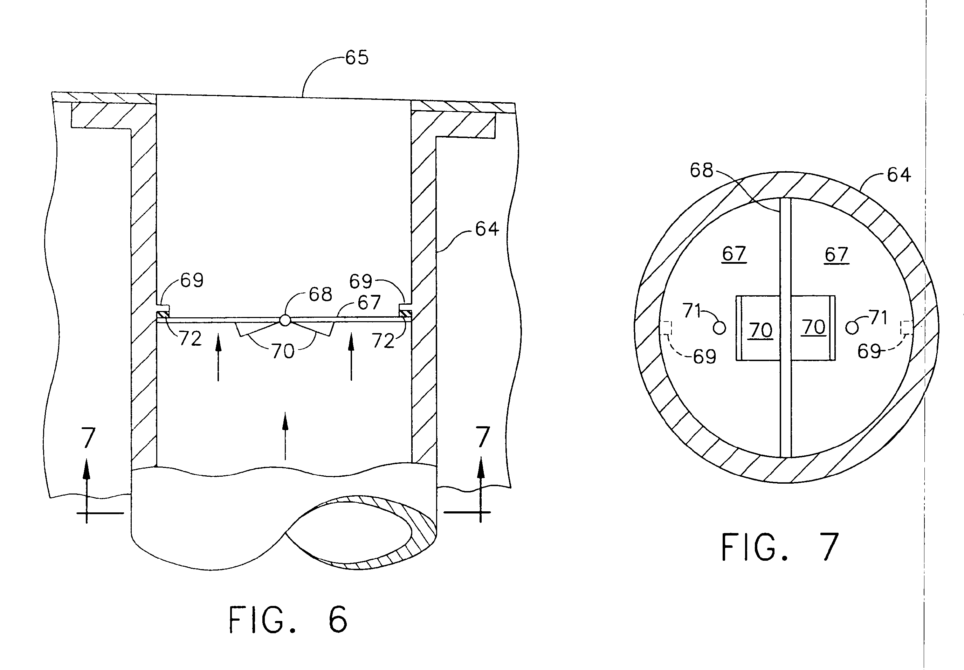

Figures 5, 6, and 7 correspond to Figures 2, 3, and 4, and illustrate comparable views of the same components but with Figures 5, 6, and 7 illustrating the reversed airflow (as indicated by the arrows) and the valve assembly 67 in a closed condition. The valve flaps are against the valve stops 69, and the apertures 71 may be sized and adapted to provide a measured amount of airflow through the substantially closed valve assembly to maintain the engine control component 60 at a desired temperature during valve-closed operation. Apertures 71 are optional, and if desired could be omitted if a total obstruction to airflow through the system were desired. Accordingly, air flows (begins to flow and closes valve, and/or continues to flow in a minor amount through apertures 71) from opening 66 on the first or inner surface 31 of the nacelle, through duct 63, through casing 61 surrounding control component 60, through duct 64 with the valve assembly 67 in the closed position, and out through opening 65 on the second or outer surface 33 of the nacelle 32. This configuration and operating condition would be typical of a high speed, high Mach number, high altitude operating condition such as cruise or other high speed flight. Under such conditions, the temperature of the air available to flow through the system is comparatively cool, therefore the amount of cooling air required to keep the control component 60 under normal operating temperature is relatively small.

Operating the system described herein with minimal or no airflow (mass flow) through the system during aircraft cruise conditions also reduces drag experienced by the aircraft, thereby reducing fuel consumption (often in terms of Specific Fuel Consumption (SFC)).

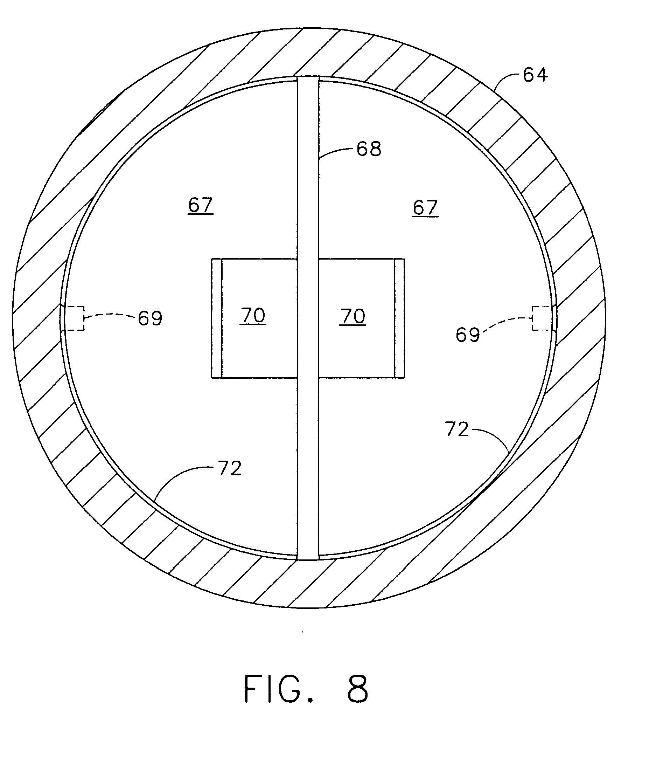

Figure 8 illustrates a variation of the valve configuration described above. In the embodiment of Figure 8, the valve flaps are sized so as to be smaller in diameter when fully closed than the diameter of the duct. This creates a gap 72, which functions similarly to the apertures 71 described above in terms of permitting a measured, comparatively small amount of airflow through and past the valve assembly 67. In contrast to the embodiment described above, the valve stop or stops 69 preferably are discrete small elements or ring segments and do not form a complete annular ring, since with the presence of gap 72 it is necessary for clearance to be provided at the edges of the valve flaps for the passage of air in the closed position.

Other placements of the valve assembly 67 in either duct 63 or duct 64 may be chosen, depending upon the characteristics of the particular application. However, orienting the valve assembly 67 as to take advantage of gravity as the biasing force to bias the valve to an open position eliminates the need for springs, solenoids, or other actuators being necessary so as to maintain a simple, reliable, lightweight design which operates automatically or passively in response to operating conditions without manual or system intervention.

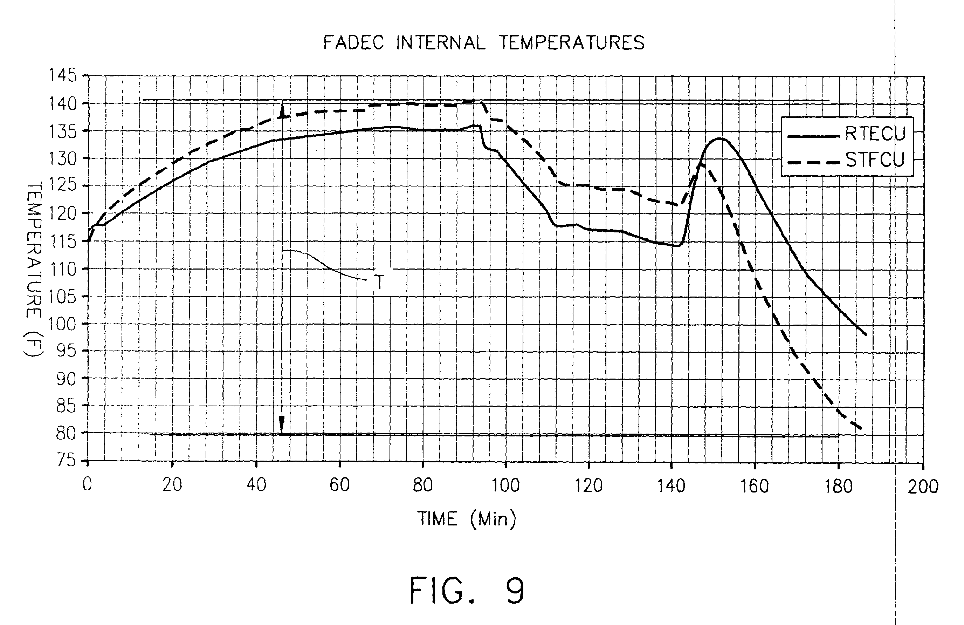

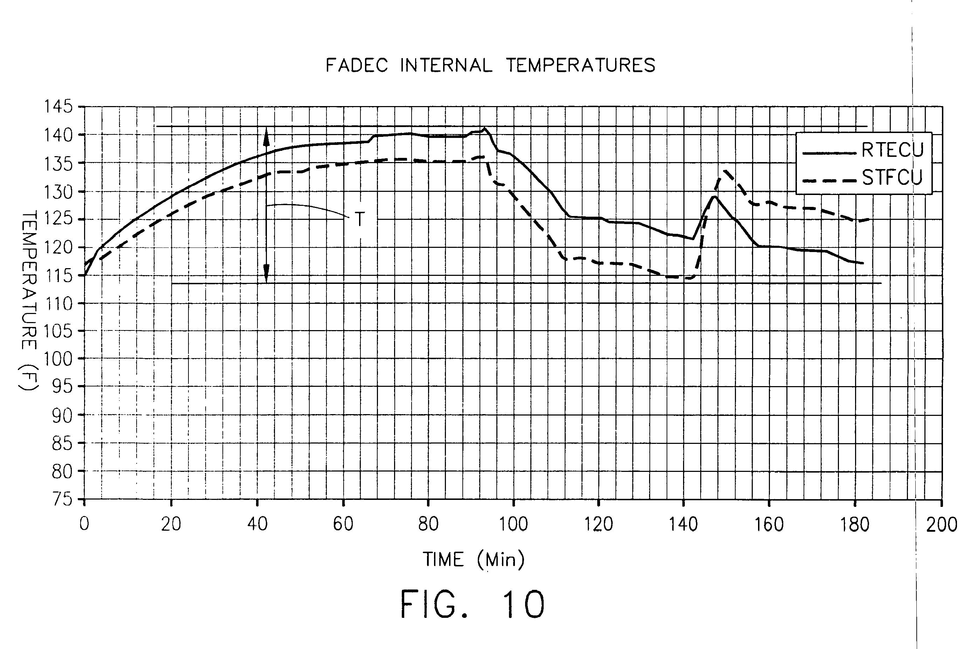

The ducts, casing, and valve assembly are sized and configured to provide particular flow characteristics needed to ensure proper temperature operation of the engine control component. Figures 9 and 10 are graphical illustrations of internal operating temperatures experienced by a FADEC unit for one particular engine application during the course of an operating session. The maximum temperature difference, denoted by the reference identifier T in Figures 9 and 10, is approximately 60 degrees Fahrenheit in Figure 9 when operating with a conventional fixed ducting system where the airflow is not regulated and approximately 25 degrees Fahrenheit in Figure 10 when a system as described herein is employed.

In the exemplary embodiment, the ducts and casing may be a fiberglass material, a graphite material, a carbon material, a ceramic material, an aromatic polyamid material such as KEVLAR, a thin metallic material such as, but not limited to, titanium, aluminum, and/or a Metal Matrix Composite (MMC) material, and/or mixtures thereof. Any suitable thermosetting polymeric resin can be used in forming the ducts and casing, for example, vinyl ester resin, polyester resins, acrylic resins, epoxy resins, polyurethane resins, bismalimide resin, and mixtures thereof. Materials should be selected based on the temperature, vibration, and flexure considerations to which the components may be exposed.

Likewise, the elements of the valve assembly may be constructed from a wide variety of suitable materials, including metals and plastics, particularly those of relatively light weight.

While much of the foregoing discussion has focused on engine control components (such as FADEC units), the systems and method described herein could be applied to other compartments requiring cooling and ventilation under similar conditions and circumstances.

This written description uses examples to disclose the invention, including the best mode, and also to enable any person skilled in the art to make and use the invention. The patentable scope of the invention is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. A system for cooling a gas turbine engine control component (60), said system comprising:
a control component (60);
at least one duct (63,64) in fluid communication with said component (60) and the atmosphere; and
a valve assembly (67) located with said duct (63,64) for modulating airflow to said component (60).

2. The system of Claim 1, wherein said valve assembly (67) is normally biased to an open position.

3. The system of Claim 1 or 2, wherein said system comprises two ducts (63,64), a first duct (63) leading from a first surface (31) of an aircraft engine nacelle structure (32) to said component (60) and a second duct (64) leading from said component (60) to a second surface (33) of an aircraft nacelle structure (32).

4. The system of any of the preceding claims, wherein said component (60) is located within an aircraft engine nacelle structure (32) between a first surface (31) of said structure (32) and a second surface (33) of said structure (32).

5. The system of Claim 4, wherein said first surface (31) is an inner surface of said structure (32) and a second surface (33) is an outer surface of said structure (32).

6. The system of any of the preceding claims, wherein said valve assembly (67) comprises a pair of pivotally mounted valve flaps.

7. The system of Claim 6, wherein said valve flaps include at least one aperture extending therethrough.

8. The system of Claim 6 or 7, wherein said valve assembly includes at least one valve stop to limit travel of said valve flaps.

9. The system of Claim 8, wherein said valve assembly includes at least two valve stops to limit travel of said valve flaps.

10. The system of Claim 8, wherein said valve stop forms a continuous annular ring.

11. The system of any of the preceding claims, wherein said valve assembly (67) is configured to operate in an open position when said component (60) requires cooling and a closed position when said component (60) does not require cooling.

12. A method for cooling a gas turbine engine control component (60), said method comprising:
providing a system for cooling said component (60), said system comprising at least one duct (63,64) in fluid communication with said component (60) and the atmosphere and a valve assembly (67) located with said duct (63,64) for modulating airflow to said component (60);
exposing said system to a first condition where cooling of said component (60) is required;
opening said valve assembly (67) in response to said first condition;
exposing said system to a second condition where cooling of said component (60) is not required; and
closing said valve assembly (67) in response to said second condition.

13. The method of Claim 12, wherein said closing step is accomplished by reversing airflow though said duct (63,64).

14. The method of Claim 12 or 13, wherein said opening and closing steps are accomplished passively.

15. A system for cooling a gas turbine engine control component, said system comprising:
a control component located within an aircraft engine nacelle structure between a first surface of said structure and a second surface of said structure;
two ducts in fluid communication with said component and the atmosphere, a first duct leading from a first surface of an aircraft engine nacelle structure to said component and a second duct leading from said component to a second surface of an aircraft nacelle structure; and
a valve assembly located with said duct for modulating airflow to said component, said valve assembly being located in said second duct adjacent to said second surface and being configured to operate in an open position when said component requires cooling and a closed position when said component does not require cooling.
